Europäisches Patentamt

European Patent Office

Office européen des brevets

(19)

(11) **EP 1 170 773 A1**

(12) **EUROPÄISCHE PATENTANMELDUNG**

(43) Veröffentlichungstag:
   **09.01.2002 Patentblatt 2002/02**

(51) Int Cl.⁷: **H01J 37/317**

(21) Anmeldenummer: **00100421.7**

(22) Anmeldetag: **03.07.2000**

(84) Benannte Vertragsstaaten:
   **AT BE CH CY DE DK ES FI FR GB GR IE IT LI LU MC NL PT SE**
   Benannte Erstreckungsstaaten:
   **AL LT LV MK RO SI**

(71) Anmelder: **Ehret, H.-P.**
   **76344 Eggenstein-Leopoldshafen (DE)**

(72) Erfinder: **Ehret, H.-P.**
   **76344 Eggenstein-Leopoldshafen (DE)**

(54) **Koaxiale ECR-Ionen- und Laser-Strahlvorrichtung und Verfahren zur Beschichtung und/oder Implantation in Materie und/oder Human- oder Tier-Gewebe**

(57)    Die Vorrichtungen und/oder Verfahren haben die Aufgabe, mittels einer ECR Ionenquelle (ECRIQ) eines aus der ECRIQ extrahiertem Ionenstrahles, der wenigstens von einem Laserstrahl koaxial überlagert ist, Materie oder Materiekombinationen des Periodensystems der Elemente, in unterschiedlichsten Objekten zu implantieren und Beschichten.

   In einer geeigneten Vorrichtung wird mittels einer ECRIQ ein anwendungs-/ prozeßkonformer Ionenstrahl erzeugt und eine Oberfläche beaufschlagt, die inenhalb einer Vorrichtung/Prozeßkammer sich befindet.

   Der koaxiale und/oder wenigstens ein seitlicher Laserstrahl - als Energieträger - hat die Aufgabe der Einstellung der interatomaren Bindungskräfte der Beschichtungsfläche und/oder des Implantationsraumes.

   Zweck der erfindungsgemäßen Vorrichtungen und/ oder Verfahrens ist die Modifizierung von Objektoberflächen und/oder deren tieferen Schichten und Implantation in Gewebe mit kurativer Zielsetzung.

EP 1 170 773 A1

**Beschreibung**

1.0 Patentanmeldung

1.1

Gegenstand der Patentanmeldung sind Vorrichtungen und Verfahren zur Oberflächenbeschichtung und/oder Implantation in Oberflächen und/oder tiefere Schichten von Solidobjekten sowie in Human- und Tiergewebe.

1.2

Die Beschichtungs- und/oder Implantationsmaterie umfaßt die Elemente des Periodensystems und deren Kombinationen.

1.2.1 Note: Alle Elemente des Periodensystems oberhalb $^{20}_{10}$ Ne sind solide.

1.3

Zielsetzung der Oberflächenbeschichtung und/oder Implantation sind gezielte Struktur- und Eigenschaftsänderungen.

1.4

Kurative und präventive Anwendung in der Medizin, z.B. At-211 Implantation in Tumorgewebe.

1.5

Anwendung in der Medizintechnik.

1.6

Beispiel Medizin: Es ist bekannt, daß Phosphor, radioaktiv, in einem z.B. Metallträger implantiert wird. Metallträger (Stent) und implantiertes radioaktives Phosphor sind angewandtes Objekt kurativer Herztherapie.

1.6.1 Der für dieses Verfahren erforderliche Ionenstrom entsprechender Energie verursacht durch Sputterprozesse apparative Konta-mination.

1.6.2 Ein großer Teil des radioaktiven Phosphors, an der Oberfläche des Metallträgers locker angelagert, verursacht eine entsorgungspflichtige Konta-mination.

1.7

Weiter ist bekannt, daß zur Steigerung des Wirkungsgrades bei Verbrennungskraftmaschinen, die Flammbeaufschlagten Flächen den Anforderungen im Hinblick auf Temperatur- und Korrosionsverhalten nicht genügen. Keramikteile die Erwartungen nicht erfüllen. Nanotechnik-Teile den Erwartungen nicht entsprechen.

1.8

Die aktuellen Erkenntnisse von Beschichtungs- und Implantationsverfahren haben weitab von theoretischen Modellen zum Teil dramatische Ergebnisse des physikalischen und chemischen Verhaltens erbracht,

1.9

Literatur gleicher Nr. 1.9 Blatt 3.

1.9.1 Jedoch, es besteht ein beachtlicher Vorrichtungs- und Verfahrensmangel.

1.10

Die Beispieldarlequng 1.6 bis 1.8 und 1.11 bewirken keine Eingrenzung der Vorrichtungen und/oder der Verfahren des Anwendungsspektrums.

1.11

Für die Anwendung des Erfindungsgemäßen Verfahrens und/oder der Vorrichtungen lassen sich derzeit keine Anwendungsgrenzen erkennen.

1.12

Es ist z.B. bekannt, daß galvanische Spuren auf Leiterplatten der bekannten Materialien und Verfahren in der Raumfahrt hohe Stör- und Ausfallraten verursachen. Implantierte Leiterspuren auf Solid-Substraten bieten eine um Größenordnungen höhere Sicherheit.

1.13

Haftungsprobleme beherrschen nach wie vor alle Sparten der Beschichtungstechnologie.

1.14

Die Beschichtungs- und Implantationstechnologie hat den Standard -die Einstellung der interatomaren Bindungsenergie für den Zeitraum des implantativen Ereignisses (nsec)- noch nicht erreicht.

1.15

Stand der Technik: Pulver-/Granulatdeponie auf der Implantationsfläche und Laserpulsbeaufschlagung oder Beschichtung und Laserpulsbeaufschlagung.

2.0 Beschreibung des Verfahrens

2.1

Das erfindungsgemäße Implantations- und/oder Beschichtungsverfahren ist dadurch gekennzeichnet, daß es z.B. mittels einer Elektronen-Cyklotron-Resonanz-Ionen-Quelle (ECRIQ), gemäß den Patentanmeldungen

2.1.1

Akt. Zeichen Nr.    195 13 345.5     EP 0 967 628 A2
196 41 439.3

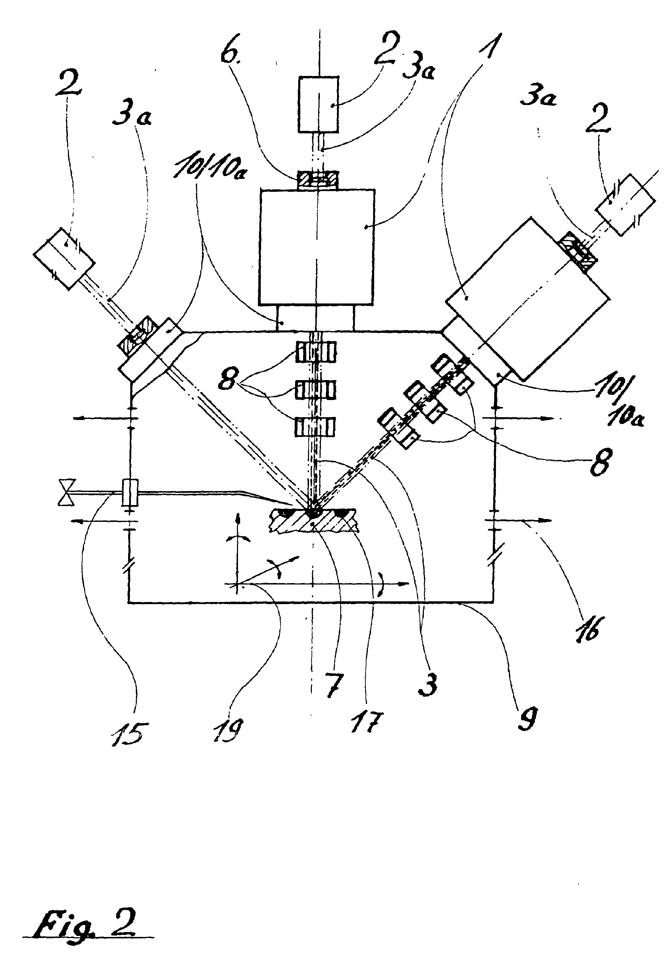

2.1.1.1 (1) Fig. 2 ein Ionenstrahl (3), bestehend aus einem oder mehreren Elementen des Periodensystems und/oder radioaktiven Elementen erzeugt. Der Ionenstrahl wird auf ein zur Implantation, in einer Prozesskammer (9) positioniertes Beschichtungs-/Implantationsobjekt (17) hin beschleunigt.

2.1.2 In der Kombination/Zusammensetzung des Ionenstrahles bestehen keine Einschränkungen, Er umfaßt alle Elemente des Periodensystems.

2.2

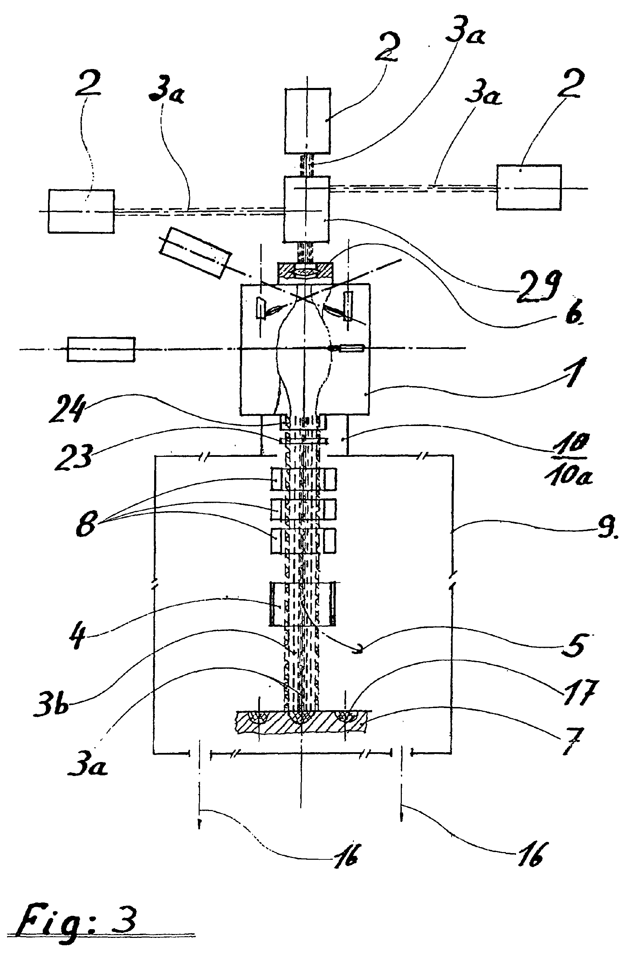

Koaxial zu dem in der ECRIQ erzeugten Ionenstrahl (3) durchläuft ein Laserstrahl (3a) prozesskonformer Energie und Wellenlänge, durch ein vakuumdichtes Laserobjektiv (6) und bilden einen Koaxialstrahl (3). Der Koaxialstrahl (3) kann aus mehreren Laserstrahlen unterschiedlicher Wellenlänge gebildet werden. Fig. 3 (2, 12).

2.2.1 Ionenstrahl und Laserstrahl in genannter koaxialer. Konfiguration beaufschlagen das Implantationsobjekt (7).

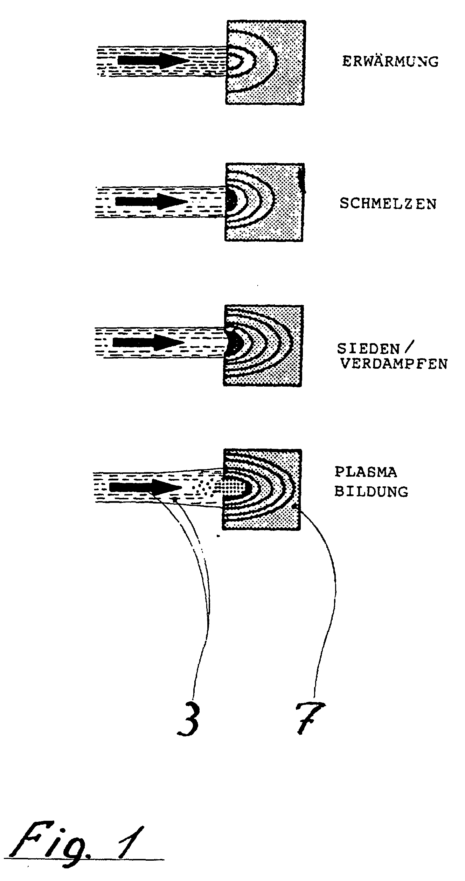

2.2.2 Prinzip-Darstellung Fig. 1.

2.3

Ionenstrahl und Laserstrahl sind so einstellbar, daß z.B. ein Laserstrahl/Laserpuls dem Ionenstrahl/Ionenpuls voreilt, vorzeitig, nachzeitig oder gleichzeitig die Implantationsfläche (7) beaufschlagt. Einstellbar ist auch der Dauerbetrieb beider Strahlarten und/oder Puls-Dauerstrahl wechselseitig.

2.3.1 Ionenstrahl- und Laserstrahlenergie, Pulsdauer und Ionenstrahlstärke sind einstellbar. Sie bestimmen die Implantationstiefe/Depottiefe, Implantationsmasse/menge pro Raumeinheit und deren räumliche Verteilung.

2.3.2 Eine der ECRIQ nachgeschaltete Ionenoptik, Ablenk- und Umlenksystem bestimmen die Ionenstrahldimension und Richtung, (4,5,8) Fig. 3. (Ionenart).

2.3.3 Note: Lichtgeschwindigkeit des Laserstrahles und die weitaus geringere Geschwindigkeit des Ionenstrahles.

2.4

Die Einstellung der Interatomaren-Bindungskräfte/Bindungsenergie im Implantationsobjekt (7) Fig. 2 erfolgt mittels Laserenergiezufuhr (2,3a) Fig. 2.

2.5

Mittels der freien Kombination von Laserstrahl (3a) und des Ionenstrahles (3b) bzw. des Koaxialstrahles (3) werden räumliche Implantationsmuster erzeugt.

2.6

Ein Verfahren der erfindungsgemäßen Art und/oder Anwendung ist aus der Literatur, eigenen Recherchen und/oder Veröffentlichungen nicht bekannt.

2.7

Verfahren der Laser-Schockhärtung sind nicht vergleichbar.

2.8

Der in 2.1.1 gegebene Bezug auf ECRIQ gemäß den Patentanmeldungen bewirken keine Einschränkung auf Ionenquellen des genannten Types.

30.0 Beschreibung der erfindungsgemäßen Implantations-/ Beschichtungsvorrichtung

30.1

Für die in 2.0 beschriebenen Implantationen bzw. Beschichtungen ist es vorteilhaft, die unter Aktenzeichen Nr. 195 13 345.5 und Aktenzeichen Nr. 196 41 439.3 Patentanmeldung beschriebenen Vorrichtungen -ECRIQ- zu verwenden.Sowie EP 0 967 628 A2.

30.1.1 Dies bedeutet keine Eingrenzung in Bezug auf die genannten Ionenquellentypen.

30.2

Der ECRIQ (1) wird ein Leistungs-Laser (2) zugeordnet. Dieser erzeugt mit dem Ionenstrahl (3b) ein koaxiales Strahlenbündel (3), Fig. 2. Das Prinzip beschreibt Fig. 1.

30.3

Dem Koaxialstrahl (3) kann ein Justierlaserstrahl zugeordnet sein. Die Laserstrahlen/Leistungs- und/oder Justierlaser wird/werden über eine vakuumdichte Laseroptik (6) Fig. 2, zentral in die ECRIQ (1) eingespeist und durchläuft diese, mit dem in der ECRIQ (1) erzeugten Ionenstrahl (3b) bis zur Beaufschlagung des Beschichtungs-/Implantationsobjektes (7), Fig.1 und Fig. 2.

30.3.1 Beschleunigungsenergie bis ca. 400 keV.

30.3.2 Der genannte Wert bedeutet keine Eingrenzung in der Höhe der Beschleunigungsspannung.

30.4

Ionenbeschleunigungselemente (23,24) und in erwähnten Patentanmeldungen sowie Ionenstrahlsteuerelemente (8,5) steuern den IONENSTRAHL IN Bezug auf Ionenenergie, Ionenstrahl-Dimension und Ionen-Selektion,Fig. 2 und Fig. 3.

30.5

Der dem Ionenstrahl (3b) überlagerte Laserstrahl (3a) hat die Aufgabe der Einstellung/Modifizierung der interatomaren Bindungskräfte mittels Energiezufuhr und ist mitbestimmend für die Implantation und Modifizierung/Einstellung der Schichtenstruktur des Implantationsobjektes (7).

30.6

Die Prozeßkammer (9) ist mit wenigstens einer Laser-ECRIQ-Kombination (1,2) ausgestattet, die zentral und/ oder seitlich/Winkel an der Prozeßkammer angeordnet ist und mittels Isolator (10/10a) von dieser galvanisch getrennt.

30.7

Der Druck innerhalb der Prozesskammer kann mittels des Vakuumpumpsystems (16) bis in den Hochvakuumbereich abgesekt werden. Fig. 1 und Fig. 2.

30.8

Zur Pr ozeßeinstellung/-Regulierung kann wenigstens ein Leistungslaser (2) (Zusatzleistungslaser) zentral und/oder seitlich/Winkel angeordnet sein, Fig. 2.

30.9

Zur Prozeßsteuerung/-unterstützung kann wenigstens eine Gaszuführung (15) an der Prozeßkammer (9) angebracht sein.

30.10

Prozeßbedingte Laserleistungserhöhung und/ oder λ-Einstellung/λ-Mischung inn- und außerhalb der ECRIQ (1) wird durch Ankoppelung mittels Laseroptiksystem (29),Fig. 3 realisiert.

30.11

Die Anordnung der Leistungslaser-ECRIQ-Kombination (1,2) incl. der Ionenstrahlsteuerelemente (8,5) sind frei kombinierbar.

30.12

Die in den Figuren gezeigte Winkeleinstellung bewirkt keine Eingrenzung bezüglich der realen Winkeleinstellung.

30.13

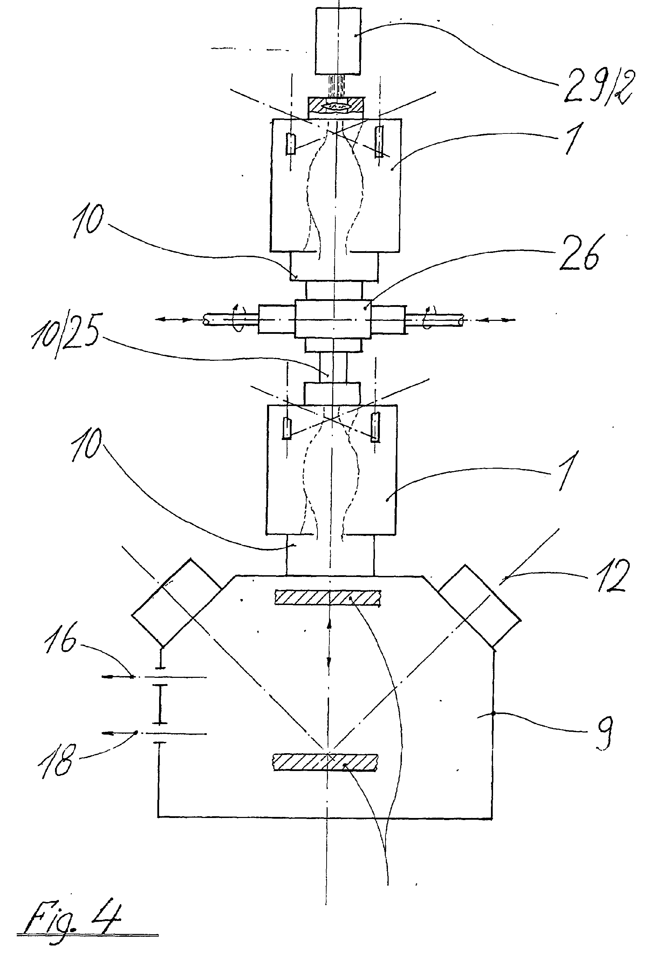

In der weiteren Ausgestaltung der erfindungsgemäßen Vorrichtung kann gemäß Fig. 4 eine Tandemanordnung erforderlich sein. (ECRIQ I + ECRIQ II).

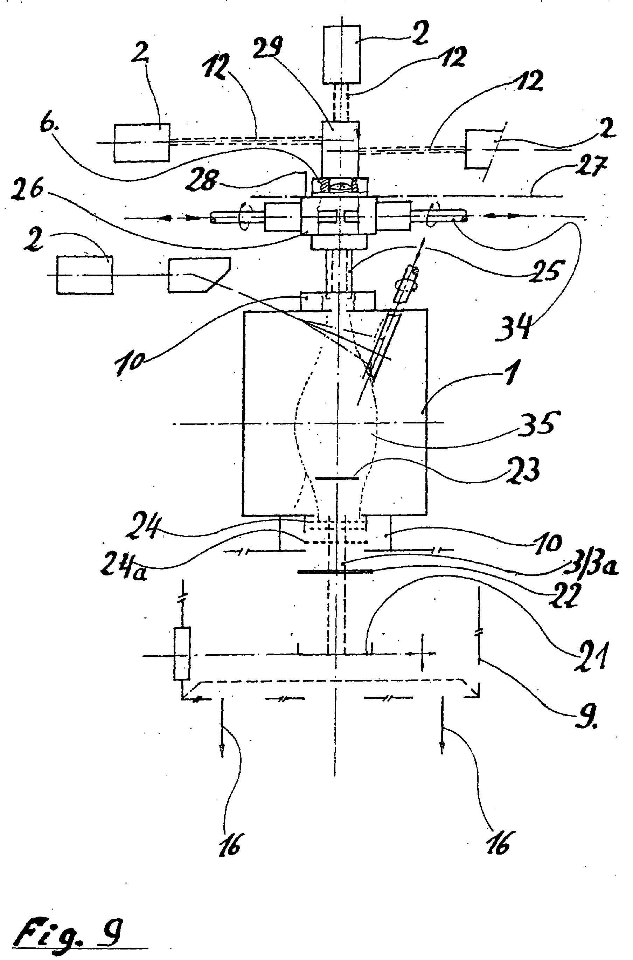

30.13.1 Insbesondere für die Herstellung von Nanopartikel und/oder Diamantscheiben. Trennstelle (27) Fig. 9.

30.14

Mittels der Bewegungsvorrichtung (19) und Ionenoptik (5,8) kann ein räumliches (17) und/oder geometrisches Prozeßmuster erzeugt werden. Einen zusätzlichen Freiheitsgrad zur Implantationsmustererzeugung ist durch das im Isolator integrierte Gelenk gegeben.

30.15

Laser (2), ECRIQ (1), Ionensteuerelemente (8), Laserobjektiv (6) und Vakuumkammer (31) kann synchron gekoppelt sein.

30.16

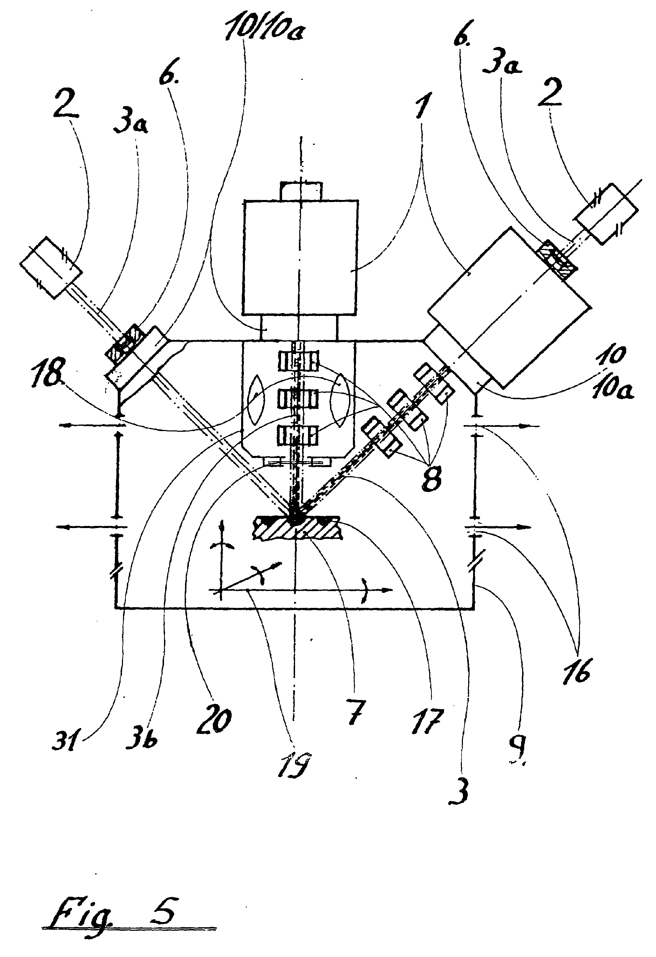

Die Vorrichtung gemäß Fig. 5 ermöglicht Implantations/Beschichtungsprozeße, die unterschiedliche ECR-Bedingungen und/oder Beschichtungs-/Implantationsbedingungen erfordern.

30.16.1 Die Gas- und Druckbedingungen für den Prozeß- und/oder die Ionenstrahlerzeugung sind innerhalb der Prozeßkammer (9) mittels der Vakuumkammer (31), Vakuumpumpsystem (18) und Ionenfenster (20) getrennt einstellbar.

30.16.2 Z.B. Implantation in Gewebe unter höchststerilen Bedingungen.

30.17

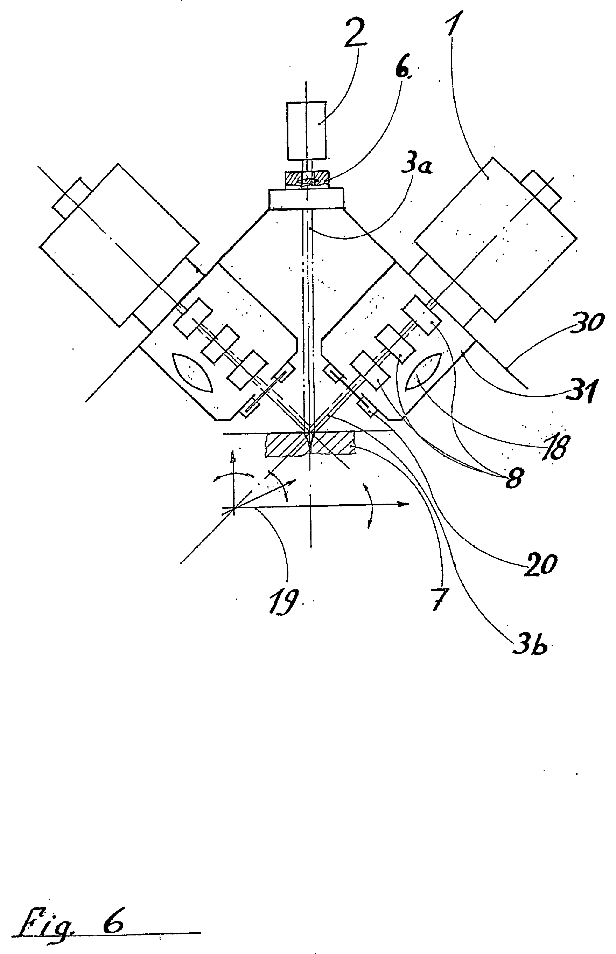

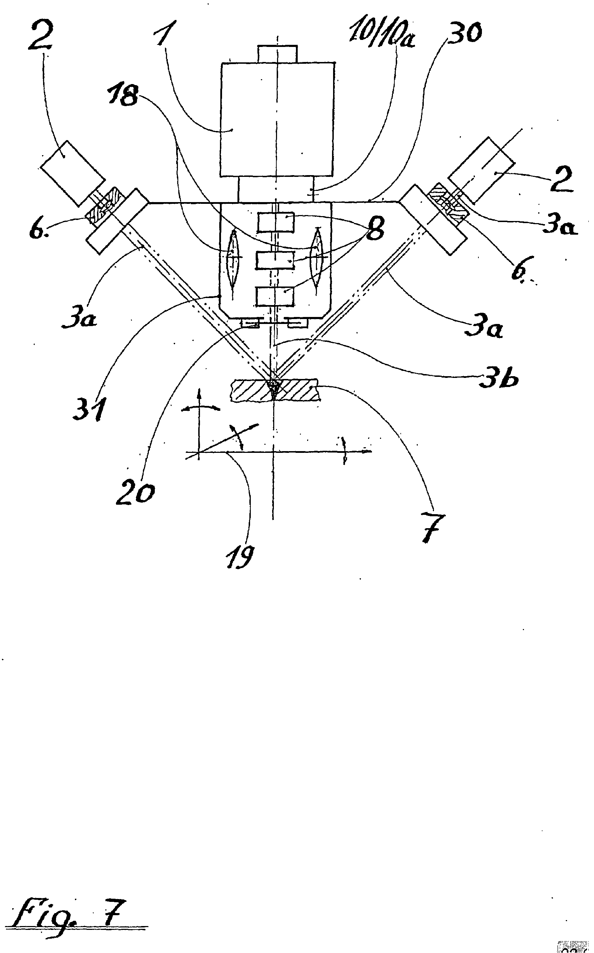

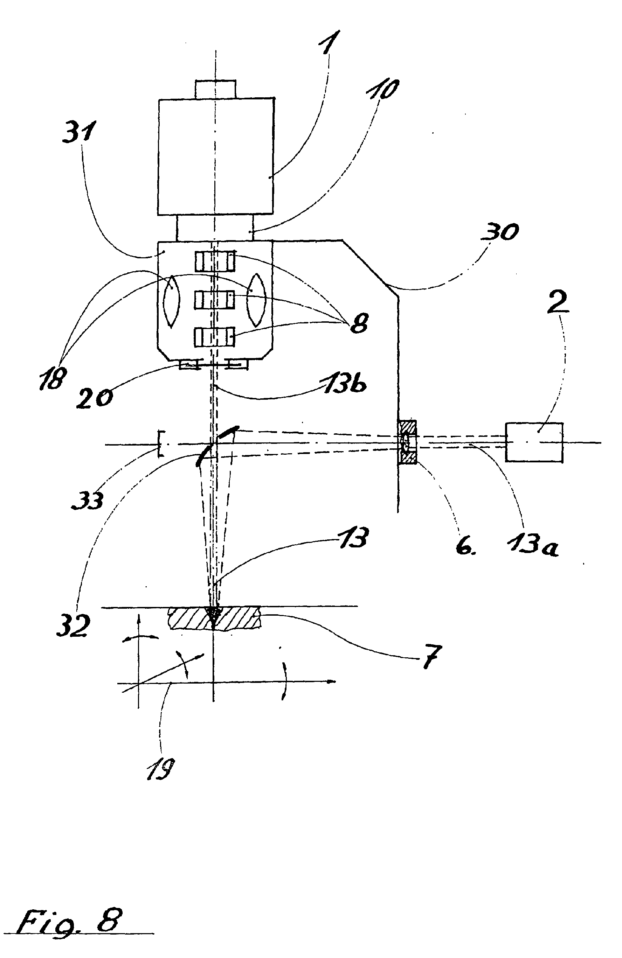

Die offenen Systeme gemäß den Fig. 6,7 und 8. Offene Systeme sind parallel zur technologischen Anwendung, primär dem medizinisc hen Sektor entsprechend, ausgestaltet.

30.17.1 Es ist bekannt, daß Tumore des Types glioblastoma multiforme (GBM)(Gehirntumor) nicht heilbar sind. Durch Ankoppelung von Astatine-211, ein $\alpha$-Strahler, an einen Antikörper, ist eine Verdoppelung der Überlebenszeit auf ca. 1 Jahr vereinzelt erreicht worden. Weiter ist bekannt, daß 1-2 $\alpha$ -Teilchen pro Humanzelle ausreichen, um Tumorsequenzen zu zerstören. Der biochemische Transport, an das Antikörpertransportsystem gekoppelt, muß mit dem $\alpha$ -Strahler den Organismus passieren.

30.17.2 Eine Direktimplantation von $^{211}_{85}$ At* bei gegebenen Umständen kann eine Zukunftsweisende Richtung vorgeben.

30.17.3 Insbesonders bei malignen Tumoren, weltweit in dramatischem Anstieg begriffen, ist die Diskussion neuer Therapieansätze zwingend.

30.18

Die erfindungsgemäße Vorrichtung Fig. 9 entspricht der Nanopartikelherstellung.

30.18.1 Sie erfordert vor dem Syntheseschritt die Zerkleine rung der Materie. Sinnvoller Weise zu Atomen und/oder Ionen, die bei Prozeßkonformen Druck-, Gas- und Energiebedingungen -kontrollierbar- zu größeren Nanoverbänden zu fügen sind.

30.19

Mittels der Laservorrichtungen (2,6,12,29) Oberhalb der ECRIQ (1) wird in der laserinäuzierten Verdampfungsvorrichtung (26) Materie (34) einer Sorte und/ oder in Mischform im Sputterprozeß, Schmelz- und/ oder Verdampfungsprozeß aufbereitet/erzeugt und mittels des Hohlzylinderisolators (25) -z.B. Saphir- oder Rubinhohlzylinder- über (10) einen Zusatzisolator, vakuumdicht verbunden, in die ECRIQ (1) eingespeist.

30.20

Eine ringförmige Laseranordnung in der Materieebene (34) an der laserinduzierten Verdampfungsanlage (26) und/oder oberhalb der Trennungslinie (27) kann erhebliche Prozeßvorteile erbringen.

30.21

Um den Massentransport aus der laserinduzierten Verdampfungsvorrichtung (26) in die Reaktionszone (35) und/oder Prozeßebene (21,22,23) zu erhöhen, kann es sinnvoll sein oberhalb der Trennlinie (27) eine zweite ECRIQ-Vorrichtung (1) anzubringen.

30.22

Das Reaktionsplasma kann, auf Grund des Plasmaextraktionsvermögens der ECRIQ (1), in den Prozeßebenen (21,22,23) eingestellt werden.

30.22.1 Diese Einstellung ist für die Herstellung von Diamantscheiben geeignet.

30.23

Zur Prozeßeinstellung ist an der laserinduzierten Verdampfungskammer (26) ein Gaseinlaß (28) vorgesehen.

Bezugsliste der Ziffernbezeichnungen

| 1 | ECR-Ionenquelle (ECRIQ) |
|---|---|
| 2 | Laser/Leistungslaser |
| 3 | Koaxialstrahl (Ionen + Laserstrahl) |
| 3a | Laserstrahl |
| 3b | Ionenstrahl |
| 4 | Ionenstrahl Umlenksystem |
| 5 | Ionenstrahl Cup |
| 6 | Laseroptik Vakuumdicht |
| 7 | Implantationsobjekt |
| 8 | Ionenoptiksystem |
| 9 | Prozeßkammer |
| 10 | Isolator |
| loa | Gelenkisolator |
| 11 | Laser |
| 12 | Laserstrahl |
| 13 | Koaxialstrahl |
| 13b | Ionenstrahl |
| 14 | nicht benannt |
| 15 | Prozeßgaseinlaß Prozeßkammer |
| 16 | Vakuumpumpsystem 1 |
| 17 | Prozeßmuster |
| 18 | Vakuumpumpsystem 2 |
| 19 | Bewegungsvorrichtung |
| 2o | Ionenfenster |

Bezugsliste der Ziffernbezeichnung

| 21 | Objekthalter |
|---|---|
| 22 | Objekthalter in Pos. 2 |

| | |
|---|---|
| 23 | Objekthalter in Pos. 3 |
| 24 | Plasmagitter |
| 24a | Beschleunigungsgitter |
| 25 | Saphir Hohlzylinder |
| 26 | Laser- (induzierte) Verdampfungskammer |
| 27 | Trennstelle |
| 28 | Gaseinlaß |
| 29 | Laseroptiksystem |
| 30 | Halterung |
| 31 | Vakuumkammer |
| 32 | Laserspiegel |
| 33 | Streustrahlschutz |
| 34 | Materie-Barren |
| 35 | Reaktionszone |

**Patentansprüche**

**31. 1** Patentanspruch Verfahren

**31. 2** Ein Verfahren **dadurch gekennzeichnet,daß** ein Objekt/Objektoberfläche/Oberfläche,gemäß Fig. 2, 5, 8 u. 9 mittels wenigstens einem Koaxialstrahl u./od.wenigstens einem Laserstrahl u./od. wenigstens einem Ionenstrahl,gemäß der /den Fig. 5, 6, 7, u, 8 beaufschlagt u./od.die Oberfläche/das Objekt strukturiert wird u./od.die beaufschlagte Materie in einen Energiezustand außerhalb/unterschiedlich dem Grundzustand der der Materie gebracht wird,mittels Zentral-u./od.Seitenstrahl/-en.

31.1.1 Erfahrungen der zu erwartenden Reaktionen sind nicht bekannt.Folglich verbietet es sich den /die Begriff/-e Oberfläche,Fläche,Objektfläche,Objektoberfläche,Objekt eng zu fassen.

**31. 2** Ein Verfahren gemäß dem Anspruch 31.1, **dadurch gekennzeichnet,daß** Koaxialstrahl,als Zentralstrahl u./od.Seitenstrahl,Laser-u./od.ionenstrahl od.Seitenstrahlen,in unterschiedlicher Zeitfolge u./od.Frequenzeinstellung ein Objekt beaufschlagen.

**31. 3** Ein Verfahren,**dadurch gekennzeichnet,daß** gemäß Anspruch 31.1 u.31.2 eine Oberfläche,Objekt incl.Human-u./od.Tiergewebe beaufschlagt u./ od.strukturiert wird.

**31. 4** Ein Verfahren gemäß den Ansprüchen 31.1 bis 31.3 **dadurch gekennzeichnet,daß** die Oberfläche/Objekt nanoscalic strukturiert wird.

**31. 5** Ein Verfahren gemäß den Ansprüchen 31.1 bis 31.4,**dadurch gekennzeichnet,daß** Materie mittels der genannten Verfahren abgetragen wird.

**31. 6** Ein Verfahren gemäß den Ansprüchen 31.5 bis 31.6, **dadurch gekennzeichnet,daß** die Fläche/das Objekt gleichzeitig u./od.in der Zeitscala vor-u./od.nachgelagert beaufschlagt,Materie angelagert u./od.implantiert wird,Materie ausgetauscht wird.

**31. 7** Ein Verfahren gemäß den Ansprüchen 31.1 bis 31.6, **dadurch gekennzeichnet,daß** die anwendbare Materie dem Umfang des Periodischem System der Elemente entspricht u. deren quantitativer Mischung/Legierung.

31.7.1 Die Verfahrensansprüche beinhalten die Nutzung/Verwendung radioaktiver Elemente.

**31. 8** Ein Verfahren gemäß den Ansprüchen 31.1 bis 31.7,**dadurch gekennzeichnet,daß** die Verfahren geschlossen,halboffen od.offen anwendbar sind.

**31. 9** Die Beschichtungs-,Materie-Implantations-,strukturierungs-,Materieabtragungs-,Materieaustauschverfahren werden in den Scalendimensionen µm bis fm (Mikrometer bis Femtometer) mittels den genannten/beschriebenen Verfahren und vorrachtungen voll beherrscht.

**4. 0** Patentanspruch/Schutzumfangsasspruch

4.0.1Vorausgesetz wird,daß die Fakten der Hochvakuumauslegeung einer Vorrichtung dem Fachmann einsichtig u.bekannt sind, u. außer besonderer Erwähnung bleiben. Die gleichen Voraussetzungen gelten für Electron-Cyclotron-Resonance-Ionen-Quellen.

4.0.2 Die Grundlage/Ursprungsidee ist in Fig.1 erklärt/dargestellt.Sie ist mit der physikalischen Erkenntnis verknüpft,daß Ionen bei Annäherung an eine Oberfläche einem Wirkungsmechanismus unterliegen der ihr Eindringen in diese bewirkt.In Kombination mit Laserenergie dramatische Wechselwirkung zeitigt u.mit der "normalen"Wärmezufuhr nicht vergleichbar ist.

4.0.3 Der Koaxialstrahl,Fig.1,ermöglicht z.B.einen Materieaustausch in Solidobjekten,mit dem Ziel einer neuartigen Oberflächenstruktur mit noch unbekannten Eigenschaften. wobei der Begriff Oberfläche weit zu fassen ist. Der bis dto.unbefriedigende Stand der Technik,Anlagerung von Materie mit mangelhafter Bindung an die Oberfläche, ist überholt.

**4. 1** Einen Vorrichtung **dadurch gekennzeichnet, daß** wenigstens eine ECR-Ionen-Quelle (ECRIQ) 1 einen zentralen,achsparallelen Durchgang/Öffnung besitzt,wie z.B.in Patent 195 133 44 realisiert.

Fig.2,Fig.3 u.weiteren Figuren.

**4. 2** Eine Vorrichtung gemäß dem Anspruch 4.1,**dadurch gekennzeichnet,daß** diese wenigstens eine Vorrichtung zur laserinduzierten Verdampfung von Materie innerhalb des Vakuumeinschlusses besitzt u.wenigsten eine Gaszufuhrvorrichtung besitzt.

**4. 3** Eine Vorrichtung gemäß den Ansprüchen 4.1 u.4.2,**dadurch gekennzeichnet,daß** die Vorrichtung wenigsten eine Laserverdampfungskammer besitzt,Fig.4/26,zur laserinduzierten Verdampfung von Materie.

4.3.1 Die Laserverdampfungskammer=laserinduzierte Materieverdampfung innerhalb einer Vakuumkammer,wenigstens eine Laserenergieeinlei.tung/-Einspeisung besitzt u.wenigstens eine vakuumdichte Materieeinbringungsvorrichtung.

4.3.2 Die Laserverdampfungskammer vor u./ od.nach der ECRIQ-Vorrichtung auf der Systemachse,Fig.4/26,u./od.wenigstens einen seitlichen vakuumdichten Anschluß zur ECRIQ-Vorrichtung hat.

**4. 4** Eine Vorrichtung gemäß den Ansprüchen 4.1 bis 4.3.2,**dadurch gekennzeichnet,daß** die Vorrichtung wenigstens einen Laser u./od.Lasersystem,Fig.3/2,3a,29,6 besitzt, dessen Laserenergiestrahl das Vorrichtungssystem zentral/auf der Systemachse durchläuft,Fig.3/2,29,6,1,10, 24,23,8,4,9 u.Fig.2 und mit dem,aus dem ECRIQ-System/der ECRIQ-Vorrichtung,mittels eines durch das Extraktionssystem/Beschleunigungssystem, Fig.3/23,24 extrahierten Ionenstrahl Fig.3/3b einen Koaxialstrahl 3a+3b=3 bildet.

4.4.1 Wobei der Ionenstrahl 3b aus unterschiedlicher Materie des Periodischen Systems der Elemente gebildet ist/gebildet sein kann.

4.4.2 Der zentrale Laserenergiestrahl bezüglich der Wellenlänge u/od.der Energie,z.B. durch Mehrfachlaserenergie-einspeisung,Fig. 3/2,3a,variabel ist/sein kann.

4.4.3 Die Laserpulsfrequenz,die Laserenergiewerte u.die Laser pulslänge sowie der Laserstrahlquerschnitt variabel sind/dem Prozeß angepaßt sind.

**4. 5** Eine Vorrichtung gemäß den Ansprüchen 4.1 bis 4.4.3, **dadurch gekennzeichnet,daß** der Koaxialstrahl ein Substraht,Solidmaterie u./od.Flüssigmaterie od.Human-u./ od.Tiergewebe beaufschlagt u.od.beschichtet u./od.die Materie implantiert.Die Materie im Normalzustand u./od.radioaktiv ist /sein kann.

**4. 6** Eine Vorrichtung gemäß den Ansprüchen 4.1 bis 4.5,**dadurch gekennzeichnet,daß** die Bildung des Koaxialstrahles 13 gemäß Fig.8/1,20,13b, 2,13a,6,32,33,7 nach dem Ionenfenster 20 u.dem Laser-Optik-System 32,33 erfolgt.

**4. 7** Eine Vorrichtung gemäß den Ansprüchen 4.1 bis 4.6, **dadurch gekennzeichnet,daß** die Zusammenführung wenigstens eines Ionenstrahles u./od. wenigstens eines Laserenergiestahles,entsprechend den Fig.5,Fig.6 u.Fig.7 unmittelbar über u./ od.auf der Objektfläche 7 erfolgt.

4.7.1 Eine Vorrichtung gemäß den Ansprüchen 4.1 bis 4.7,**dadurch gekennzeichnet,daß** gemäß Fig.5/1,10,31,20,18 einerseits u.2,3a, 6,1,10,3,9,16, andererseits eine druck-differenzierte Einstellung der Ionenimplantation u./ od. Ionenbeschichtung ermöglicht.Der Laserenergiestrahl Fig.5/2,3a,6 unmittelbar über u./ od.auf dem Objekt 7 einen Quasikoaxialstrahl bildet.

**4. 8** Eine Vorrichtung gemäß den Ansprüchen 4.1 bis 4.7,**dadurch gekennzeichnet,daß** wenigsten zwei ECR-Systeme entsprechend Fig.4 u.Fig.8 u./ od.gemäß Anspruch 4.4 bis 4.4.2 wenigstens ein Laserenergiestrahl die Vorrichtung zentral durchläuft u./od.gemäß Anspruch 4.7 nach dem Ionen-Austrittfenster 20 oder ohne Strahlaüstrittsfenster 20,gemäß Fig.5 u. Fig.8,mittels eines Laserspiegel-Optiksystems fig.8/6,32,33 einen Koaxialstrahl Fig. 8/13 gebildet wird.

**4. 8** Der Prozeßkammer Fig.4/9 ist/kann wenigsten ein Seitenlaser 12 zugeordnet./werden.

**4. 9** Eine Vorrichtung gemäß den ansprüchen 4.1 bis 4.8,**dadurch gekennzeichnet,daß** der Ionenstrahlanteil 3b des Koaxialstrahles,aus wenigstens einer ECRIQ-Vorrichtung,kontinuierlich u./od.gepulst,dem Laserenergiestrahl-Anteil des Koaxialstrahles vorauseilend,gleichzeitig u./od.nachzeitig, in Bezug auf die Objektbeaufschlagung 7 einstellbar ist.

4.9.1 Der Anspruch ist wirkungsgemäß/sinngemäß auf die Vorrichtungen Fig.2,Fig.4,Fig. 5,Fig.6,Fig.7,Fig.8 u.Fig.9 gestellt.

**4. 10** Eine Vorrichtung gemäß den Ansprüchen 4.1 bis 4.9,**dadurch gekennzeichnet,daß** die Objektbeaufschlagung 7 mittels wenigstens einer ECRIQ-Vorrichtung u./od.Laserenergiestrahlvorrichtung u./

od.wenigstens einer ECRIQ-Ionenstrahl-Laserenergiestrahl-Vorrichtung(Koaxialstrahl-Vorrichtung) erfolgt,entsprechend den Fig.2,Fig. 5,Fig.6.u.Fig. 7.Die Zusammenführung/Zusammenwirkung unmittelbar über u./od.auf der Objektoberfläche erfolgt.

**4. 11** Eine Vorrichtung gemäß den Ansprüchen 4.1 bis 4.10,**dadurch gekennzeichnet,daß** ECRIQ-Vorrichtung u./od. Prozeßkammer u./od. Prozeßkammer der Unterdruck-/Vakuumeinstellung,Fig.5/20,18,9,16 getrennt/trennbar ist.

**4. 11** (Z.B.zur Implantation in Lebendgewebe).Wobei die Restgasmenge ein prozeßspezifisches Gas od.Gasgemisch ist/sein kann u. eine Vorrichtung, Fig.2/15,zur Objektgasbeaufschlagung besitz/besitzen kann.

**4. 12** Eine Vorrichtung gemäß den Ansprüchen 4.1 bis 4.11,**dadurch gekennzeichnet,daß** die Objektbeaufschlagung,Beschichtung u.od.Implantation u./od.der Materieaustausch ein offener Prozeß,Fig. 6,Fig.7,Fig.B,ist,mit od.Prozeßgasbeaufschlagung 15,od.ein halboffener Prozeß, Fig.5, od.ein geschlosserner Prozeß ist.Gemäß den Figuren 5/18, 20,9,16;6/20,18,3b,3a,30;7/18,20,3a,3b,30; 8/18,20,13b, 13,30.

Fig. 1

**Fig. 2**

**Fig: 3**

Fig. 4

*Fig. 5*

*Fig. 6*

**Fig. 7**

Fig. 8

**Fig. 9**

**Europäisches Patentamt**

## EUROPÄISCHER RECHERCHENBERICHT

Nummer der Anmeldung

EP 00 10 0421

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | GB 2 112 205 A (AHMED HAROON;MCMAHON RICHARD ANTHONY) 13. Juli 1983 (1983-07-13) * das ganze Dokument * | 1-33 | H01J37/317 |
| X | DE 36 21 045 A (NIPPON TELEGRAPH & TELEPHONE) 2. Januar 1987 (1987-01-02) * das ganze Dokument * | 1-33 | |
| X | DD 231 522 A (MITTWEIDA ING HOCHSCHULE) 2. Januar 1986 (1986-01-02) * das ganze Dokument * | 1-33 | |
| D,A | EP 0 967 628 A (EHRET H P) 29. Dezember 1999 (1999-12-29) * das ganze Dokument * | 4 | |

RECHERCHIERTE SACHGEBIETE (Int.Cl.7)

H01J
H05H
G21K

Der vorliegende Recherchenbericht wurde für alle Patentansprüche erstellt

| Recherchenort | Abschlußdatum der Recherche | Prüfer |
|---|---|---|
| DEN HAAG | 27. März 2001 | Schaub, G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie,übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 00 10 0421

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-03-2001

| Im Recherchenbericht angeführtes Patentdokument | Datum der Veröffentlichung | Mitglied(er) der Patentfamilie | Datum der Veröffentlichung |
|---|---|---|---|
| GB 2112205 A | 13-07-1983 | KEINE | |
| DE 3621045 A | 02-01-1987 | JP 1925376 C | 25-04-1995 |
| | | JP 6054648 B | 20-07-1994 |
| | | JP 61294749 A | 25-12-1986 |
| | | JP 61294748 A | 25-12-1986 |
| | | JP 62031931 A | 10-02-1987 |
| | | US 5006795 A | 09-04-1991 |
| DD 231522 A | 02-01-1986 | KEINE | |
| EP 0967628 A | 29-12-1999 | DE 19641439 A | 07-05-1998 |

EPO FORM P0461

Für nähere Einzelheiten zu diesem Anhang : siehe Amtsblatt des Europäischen Patentamts, Nr. 12/82